# EUROPÄISCHE PATENTSCHRIFT

(11) **EP 1 927 139 B1**
(45) Veröffentlichungstag und Bekanntmachung des Hinweises auf die Patenterteilung: **02.05.2012**
(21) Anmeldenummer: 06792050.4
(22) Anmeldetag: 14.09.2006
(51) Int. Cl.: H01L 31/0224, H01L 31/0216, H01L 27/142

(54) **VERFAHREN ZUR BEARBEITUNG VON SOLARZELLEN MIT LASERGESCHRIEBENEN GRABENKONTAKTEN**
METHOD FOR PROCESSING OF SOLAR CELLS HAVING LASER-WRITTEN TRENCH CONTACTS
PROCEDE POUR USINER DES PILES SOLAIRES AVEC DES CONTACTS DE TRANCHEE INSCRITS AU LASER

(30) Priorität: 19.09.2005 DE 102005045704
(43) Veröffentlichungstag der Anmeldung: 04.06.2008
(73) Patentinhaber: Gebr. Schmid GmbH, 72250 Freudenstadt (DE)
(72) Erfinder: SCHMID, Christian, 72250 Freudenstadt (DE)
(74) Vertreter: Patentanwälte Ruff, Wilhelm, Beier, Dauster & Partner
(86) Internationale Anmeldenummer: PCT/EP2006/008932
(87) Internationale Veröffentlichungsnummer: WO 2007/033788

(56) Entgegenhaltungen:
- EP-A- 1 733 426
- WO-A-00/01019
- WO-A-00/22681
- WO-A-01/33639
- WO-A-2005/083799
- WO-A2-2005/086633
- AU-B2- 565 214
- AU-B2- 729 342
- DE-A1- 4 217 428
- US-A- 4 726 850
- JENSEN J A D ET AL: "ELECTROCHEMICAL DEPOSITION OF BURIED CONTACTS IN HIGH-EFFICIENCY CRYSTALLINE SILICON PHOTOVOLTAIC CELLS" JOURNAL OF THE ELECTROCHEMICAL SOCIETY, ELECTROCHEMICAL SOCIETY. MANCHESTER, NEW HAMPSHIRE, US, Bd. 150, Nr. 1, 2003, Seiten G49-G57, XP001090500 ISSN: 0013-4651

## Beschreibung

Die Erfindung betrifft ein Verfahren zur Bearbeitung von Solarzellen, wobei auf einer Oberseite der Substrate eine aktive Schicht mit einer Anti-Reflex-Schicht darüber vorgesehen ist, gemäß den Schriffen nach Anspruch 1.

Bei der Herstellung bzw. Bearbeitung von beispielsweise Solarzellen auf Siliziumwafern weisen diese eine aktive Schicht aus Silizium auf, an der zum einen vorderseitige Kontaktierungen angebracht werden müssen. Des weiteren wird zur Erhöhung des Wirkungsgrades der Solarzellen vielfach eine Anti-Reflex-Schicht aufgebracht. Vom Verfahrensablauf her wird zuerst die Anti-Reflex-Schicht aufgebracht und dann erst die Kontaktierungen.

Des weiteren sind sogenannte Buried Contact-Zellen bekannt, bei denen mit einem Laser Gräben in der Tiefe von 20-30µm durch die SiNx-Anti-Reflex-Schicht erzeugt werden. Die Gräben werden gereinigt und anschließend erneut wieder mit einer höheren Dotierung als auf der Oberfläche versehen. Als nächster Schritt wird chemisch Nickel aufgebracht und dieses anschließend durch einen mehrminütigen Prozess in einem Ofen bei ca. 400 C° behandelt. Anschließend wird eine chemische oder eine galvanische Kupfer-Schicht aufgebracht. Nachteile hierbei sind hohe Prozesskosten, durch den erneuten Hochtemperaturprozess zur Dotierung kann eine Beschädigung des SiNx bzw. negative Veränderung in der Silizium-Gefügestruktur auftreten und ein Temper-Prozess bedeutet eine erneute Belastung der Aluminiumrückseite der Substrate.

Die WO 2005/083799 A1 beschreibt ein Verfahren zur Bearbeitung von Solarzellen, auf deren Oberseite Gräben erzeugt werden. In diese Gräben wird ein Kontaktmaterial eingebracht. Anschließend wird die gesamte Solarzelle erhitzt in einer Atmosphäre, die mit bestimmten Gasen versetzt ist bzw. diese enthält.

Der Artikel von Jensen J. A. D. et al. "Electrochemical Deposition of Buried Contacts in High-Efficiency Crystalline Silicon Photovoltaic Cells" in Journal of The Electrochemical Society, Bd. 150, Nr. 1, 2003, Seiten G49 bis G57, XP-001090500 ISSN: 0013-4651 beschreibt ein Verfahren, bei dem in Gräben auf einer Vorderseite einer Solarzelle Linienkontakte erzeugt werden können. Diese Erzeugung erfolgt durch elektrochemisches Abschalten von Kontaktmaterial.

Die AU 199668036 B2 beschreibt, wie an der Vorderseite einer Solarzelle ein Einschmelzen des Kontaktmaterials in Gräben in einem Diffusionsofen erfolgt.

Die AU 565 214 B beschreibt ein weiteres Verfahren, bei dem in Gräben in der Vorderseite einer Solarzelle mittels eines Lasers gebildet werden und auf der Vorderseite Linienkontakte aus metallischem Kontaktmaterial erzeugt werden. Hier erfolgt ein Erhitzen des in die Gräben eingebrachten Kontaktmaterials durch Bestrahlen der mit den Gräben versehenen Bereiche mit einem Laser.

### Aufgabe und Lösung

Der Erfindung liegt die Aufgabe zugrunde, ein eingangs genanntes Verfahren zu schaffen, mit dem das Anbringen von Kontaktierungen an der Vorderseite einer aktiven Schicht einer Solarzelle, über der eine Anti-Reflex-Schicht verläuft, verbessert werden kann.

Gelöst wird diese Aufgabe durch ein Verfahren mit den Merkmalen des Anspruchs 1. Vorteilhafte sowie bevorzugte Ausgestaltung der Erfindung sind Gegenstand der weiteren Ansprüche und werden im Folgenden näher erläutert. Der Wortlaut der Ansprüche wird dabei durch aufdrückliche Bezugnahme zum Inhalt der Beschreibung gemacht.

Erfindungsgemäß ist vorgesehen, dass Gräben oder Kanäle in der Anti-Reflex-Schicht erzeugt werden, die bis auf die aktive Schicht darunter reichen. Diese Gräben werden mit einem Laser erzeugt, und zwar im gepulsten oder im Dauerbetrieb. In einem Beispiel, das nicht unter die beanspruchte Erfindung fällt, können die Gräben auch mechanisch erzeugt werden. Danach wird ein Kontaktmaterial in den Graben eingebracht bzw. auf den Grabenboden aufgebracht, beispielsweise Nickel oder Silber. Dies kann durch genaues bzw. gezieltes Aufbringen des Kontaktmaterials gemacht werden, beispielsweise mit einer Art Ink-Jet-Verfahren ähnlich einem Druckverfahren, alternativ chemisch oder galvanisch. Anschließend wird das Kontaktmaterial in den Gräben erwärmt bzw. erhitzt zur Verbindung nut dem Material der angrenzendenaktiven Schicht, wobei das Erwärnen bzw Erhitzen des Kontaktmaterials lokal nur in dem Kontaktmaterial in den Gräben durch Bestrahlung nur des Kontaktmaterials nut einem Laser stattfindet.

Die Pulsenergie des Lasers kann hierbei so gewählt werden, dass die Anti-Reflex-Schicht entfernt wird, aber das darunter liegende Silizium der aktiven Schicht auch bei mehrmaligem Beschuss mit Laserpulsen nicht abgetragen wird. Die Laserwellenlänge liegt zwischen 260nm und 1065nm, die Flächenleistungsdichte pro Puls liegt zwischen 3 bis 50J/cm², die Pulsdauer liegt zwischen 1ns und 200ns, vorteilhaft zwischen 50ns und 100 ns.

Ein vorteilhaft verwendeter Nd:YLF-Laser, der ähnlich einem üblichen Nd:YAG-Laser ist, aber ein leicht abgewandeltes Trägerglas hat, hat eine Grundwellenlänge von 1047nm, die Vervierfachte davon hat 261,7nm. Der Nd:YAG-Laser hat eine Grundwellenlänge von etwas über 1064nm. Dies ergibt einen Gesamtbereich von 261nm - 1065nm für Laserbearbeitung.

Bei der Flächenleistung zählt die Leistungsdichte pro Fläche. Man kann den Strahl auch vergrößern und dann die Pulsleistung erhöhen, insofern ist hier die Flächenleistung ausschlaggebend, wie sie oben angegeben ist.

Die vorderseitige Kontaktierung kann wie beschrieben gebildet werden. Durch das Erwärmen kann vorteilhaft auch der elektrische Übergangswiderstand zwischen vorderseitiger Kontaktierung bzw. Kontaktmaterial und der aktiven Schicht verringert werden. Dies wiederum erhöht die Leistungsfähigkeit bzw. den Wirkungsgrad der Solarzelle.

Es ist möglich, nach dem Erzeugen der Gräben bzw. vor dem Einbringen des Kontaktmaterials die Substrate bzw. die Oberseite der aktiven Schicht zu reinigen, beispielsweise durch spülen. Dazu kann eine alkalische, saure oder HF-Spülung der Oberseite des Substrats vorgenommen werden, ebenso ist ein Ausblasen odgl. möglich. So können Verunreinigungen sowie Abscheidungen, beispielsweise kleine Splitterteile von der Grabenerzeugung, aus den Gräben bzw. von dem Grabenboden entfernt werden. Ebenso können entstandene Oxid-Schichten entfernt werden. Die Reinigung bzw. die Spülung der Gräben kann vorteilhaft auch etwas von dem aktiven Material abtragen. So wird die Oberfläche der aktiven Schicht besser vorbereitet für das anschließende Aufbringen des Kontaktmaterials.

Vorteilhaft wird auch noch eine Dotierung des Materials der an die Gräben bzw. die Kontakte angrenzenden aktiven Schicht vorgenommen, also im Silizium. Dies kann beispielsweise dazu dienen, Schäden in der aktiven Schicht, die durch die Erzeugung des Grabens bzw. die Laserbestrahlung entstanden sind, wieder zu beseitigen.

In einer Ausführung der Erfindung wird das Dotiermaterial dem Kontaktmaterial beigemischt, sie werden also gleichzeitig eingebracht. Dabei liegt ein großer Vorteil darin, dass durch ein- und dasselbe Material, nämlich ein gemeinsames Kontakt- und Dotiermaterial, also auch nur mit einem einzigen Verfahrensschritt, sowohl eine Kontaktierung des Substrates als auch eine Dotierung des Materials der aktiven Schicht erfolgt. Neben den allgemeinen Vorteilen der Dotierung kann des weiteren dadurch gleich die vorderseitige Kontaktierung hergestellt werden. Das Dotiermaterial kann beispielsweise Phosphor, insbesondere also das Kontakt- und Dotiermaterial NiP sein. Der Phosphor-Bestandteil dient bei bzw. nach dem Erwärmen oder Erhitzen zur Dotierung der aktiven Schicht. Der Nickel-Bestandteil bildet einen sehr guten elektrischen Leiter für die vorderseitige Kontaktierung. Des weiteren ist der Übergangswiderstand von Nickel zu der aktiven Schicht aus Silizium gering.

Das Erwärmen bzw. Erhitzen des eingebrachten Kontakt- und Dotiermaterials erfolgt lokal sehr begrenzt. Erfindungsgemäß erfolgt es lediglich im Bereich der Gräben bzw. in den Gräben selber auf ihrem Grabenboden, also dort, wo sich das eingebrachte Kontakt- und Dotiermaterial befindet. Gemäß der Erfindung folgt das Erwärmen durch Bestrahlen mit einem entsprechend geeignerten Laser. Dabei können dessen Betriebsparameter auf die speziellen Eigenschaften des Kontakt- und Dotiermaterials abgestellt sein. Während der Laserbestrahlung erfolgt also die Dotierung des angrenzenden Materials aus der aktiven Schicht über den Phosphor-Bestandteil. Gleichzeit oder auch in einem nachfolgenden zweiten Schritt kann das Kontakt- und Dotiermaterial erneut erwärmt bzw. erhitzt werden, um den Nickelbestandteil zum Schmelzen zu bringen zur Bildung der vorderseitigen Kontakte bzw. Kontaktbahnen. Dies erfolgt wieder über Laserbestrahlung . Da üblicherweise mehrere solcher Kontaktbahnen aufgebracht werden, bilden sie ein Kontaktmuster. In einen Beispiel, das nicht unter die beanspruchte Erfindung fällt, ist es austelle einer Erwärmung des eingebrachten Kontakt- und Dotiermaterials mit einem Laser auch möglich, hier entlang der Kontakte sehr dünne und ausreichend leistungsfähige Heizdrähte odgl. Zur Erwärmung des Kontaktmaterials vorzusehen.

Eine Vorrichtung zur Durchführung des Verfahrens weist also mindestens eine Bearbeitungsstation mit einem Laser auf. Diese wird entweder mehrfach zur Bearbeitung der Solarzelle angefahren, oder es sind mehrere Laser-Stationen vorgesehen. Des weiteren ist eine Einrichtung zum Einbringen des Kontakt- und Dotiermaterials in die Gräben vorgesehen.

Besonders vorteilhaft bei der Erfindung ist also das Aufbringen eines Materials, welches sowohl die Aufgabe der Kontaktierung als auch die Aufgabe der Dotierung der aktiven Schicht übernimmt. Hierdurch kann dieser Prozessschritt vereinfacht werden.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unter-kombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:

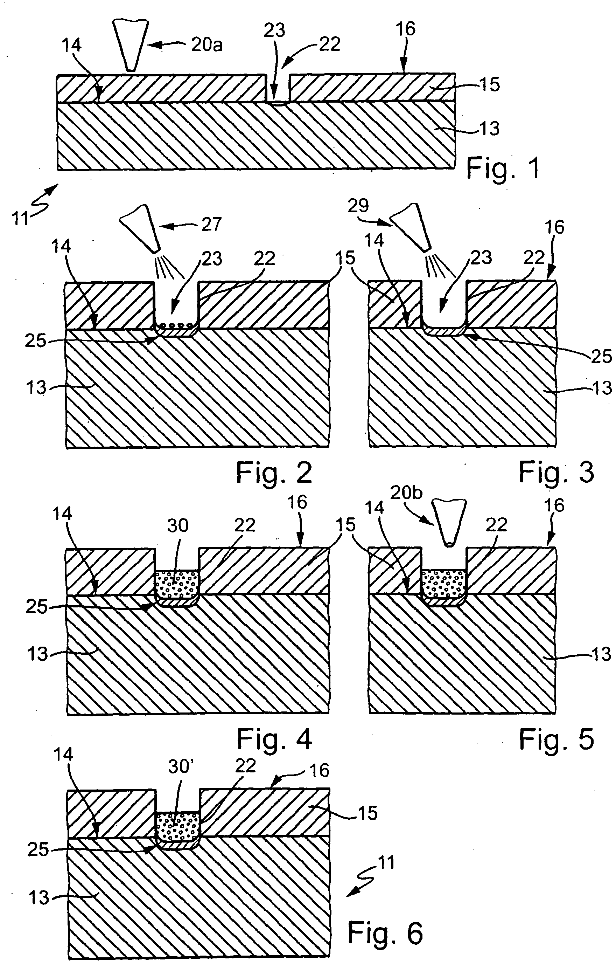

- Fig. 1 bis 6: verschiedene Verfahrensschritte zum Strukturieren eines Wafers für eine Solarzelle' und zum Aufbringen der Kontaktierungen.

### Detaillierte Beschreibung der Ausführungsbeispiele

In Fig. 1 ist eine Solarzelle 11 dargestellt, die eine aktive Schicht 13 aus Silizium aufweist. Auf die Oberseite 14 der aktiven Schicht 13 ist eine Anti-Reflex-Schicht 15 aufgebracht. Diese kann beispielsweise aus SiNₓ bestehen. Dieser Aufbau ist für einen Fachmann bekannt.

Wie aus Fig. 1 zu ersehen ist, wird mittels eines Lasers 20a, der die Oberseite 16 der Anti-Reflex-Schicht 15 bestrahlt, ein Graben 22 darin erzeugt. Mehrere Gräben 22 werden parallel zueinander mit einem bestimmten Abstand vorgesehen, und zwar so, wie Kontaktierungen an der Solarzelle 11 vorhanden sein sollen. Dabei ist aus Fig. 1 zu erkennen, dass der Grabenboden 23 in etwa im Bereich der Oberseite 14 der aktiven Schicht 13 liegt. Dies bedeutet, dass im Graben 22 auf seiner Breite das gesamte Material der Anti-Reflex-Schicht abgetragen wird.

Eine mögliche Lasereinstellung ist:

Pulsenergie 25-80 µJ/Puls, Fokusdurchmesser etwa 22µm, Flächenleistung 6,5 bis 21 J/cm², Wellenlänge 532nm, Pulsdauer 70ns.

Aus der Vergrößerung in Fig. 2 ist zu erkennen, dass im Bereich des Grabenbodens 23 ein beeinträchtigter Bereich 25 im Material der aktiven Schicht 13 gebildet ist. Hier ist das aktive Material 13 sozusagen beschädigt durch die Einwirkungen des Lasers 20a. Dies gilt es noch zu beseitigen, was nachfolgend genauer ausgeführt wird.

Des weiteren befinden sich auf dem Grabenboden 23 kleine Verunreinigungen in Form von kleinen Teilen odgl. Mit einer Spülung 27 werden diese aus dem Graben 22 entfernt, so dass die Solarzelle 11 gemäß Fig. 3 vorliegt. Dabei liegt der Grabenboden 23 mit dem beeinträchtigten Bereich 25 an der Oberseite der aktiven Schicht 13 frei.

Des weiteren kann in dem Schritt gemäß Fig. 2 und 3 vorgesehen sein, dass bei der Spülung bzw. Entfernung der Verunreinigungen auf dem Grabenboden 23 etwas Silizium abgetragen wird, insbesondere von dem beeinträchtigten Bereich 25. Dadurch kann sozusagen ein sauberer Grabenboden 23 erreicht werden, was für eine nachfolgende Kontaktierung von Vorteil ist.

Gemäß Fig. 3 wird eine Beschichtungsvorrichtung 29 dazu verwendet, Beschichtungsmaterial bzw. Kontakt- und Dotiermaterial in den Graben 22 einzubringen, wie dies vorstehend beschrieben worden ist. Dies ist in Fig. 4 dargestellt, und zwar nach Abschluss des Einbringens des Materials. Das Kontakt- und Dotiermaterial kann, wie zuvor erwähnt worden ist, NiP sein. Genaueres wird hierzu nachfolgend noch erläutert.

Anschließend wird gemäß Fig. 5 mit einem zweiten Laser 20b das Material 30 bestrahlt bzw. in dem Graben 22 erwärmt oder erhitzt. Bei dieser Erhitzung, die somit lokal nur in den Gräben 22 bzw. in dem Material 30 stattfindet, wird durch das Phosphor eine Dotierung in das benachbarte aktive Material 13 vorgenommen. Insbesondere wird dabei der beeinträchtigte Bereich 25 dotiert. Dies bewirkt sozusagen ein Reparieren der aktiven Schicht 13 bzw. ein Beseitigen der durch die Grabenerzeugung entstandenen Schäden in der aktiven Schicht. Die für den Dotiervorgang notwendige Hitze wird durch den Laser 20b erzeugt, kann jedoch auch durch alternative Verfahren erzeugt werden, wobei die Hitze lokal aufgebracht werden sollte.

Zusätzlich zu der Reparatur des beeinträchtigten Bereichs 25 dient die unter Umständen relativ starke ++-Dotierung dieses Bereichs dazu, einen möglichst geringen Übergangswiderstand zu dem vorderseitigen Kontakt 30' zu bilden, der gemäß Fig. 6 am Ende vorliegt. Als Material für die Kontakteigenschaften ist Nickel besonders gut geeignet wegen des geringen Übergangswiderstandes zu Silizium. Ebenso kann auch Silber verwendet werden. Der Phosphor-Anteil in dem Kontakt- und Dotiermaterial dient zur Dotierung des Materials der aktiven Schicht 13. Selbst wenn kein durch die Erzeugung des Grabens 22 beeinträchtigter und beschädigter Bereich 25 vorliegt, weist die Dotierung mit dem Phosphor oder unter Umständen auch einem anderen Material den Vorteil auf, dass der Übergangswiderstand zu dem fertigen Kontakt 30' reduziert wird.

Mit der in dieser Hinsicht fertiggestellten Solarzelle 11 gemäß Fig. 6 ist das erfindungsgemäße Verfahren abgeschlossen. Wie allgemein von Solarzellen bekannt, können diese fertigen Kontakte 30' in bestimmten Abständen vorgesehen sein als vorderseitige Kontaktierung der Solarzellen 11.

Besonders wichtig ist für eine Ausführung des erfindungsgemäße Verfahrens, dass sowohl das Kontaktmaterial als auch das Dotiermaterial in einem Schritt bzw. gemeinsam oder als gemischtes Material aufgebracht werden. Dadurch kann erheblicher Aufwand eingespart werden und es wird eine sehr gut funktionierendes Solarzelle 11 erzeugt.

Weitere Varianten sind in Kurzbeschreibung:

### Variante 1:

Ausgangsmaterial ist ein dotierter Si-Wafer als Substrat, der auf der Vorderseite eine Anti-Reflex-Schicht (SiNx) aufweist, auf der Rückseite Aluminium und Silber oder wahlweise ein anderes Metall.

In die Anti-Reflex-Schicht der Vorderseite werden mittels Laser mehrere Gräben geschnitten. Die Gräben öffnen das SiNx, durch entsprechend gewählte Laserparameter jedoch nicht die aktive Schicht. Optional wird dann der durch den Laser erzeugte Graben wieder gereinigt (sauer oder alkalisch) und evtl. entstandenes Oxid odgl. wieder entfernt.

Chemisch Nickel oder galvanisch Nickel wird als Barrier-Schicht und zur Verbesserung des Übergangswiderstands eingebracht. Optional erfolgt eine Einbringung des Nickels durch ein Druckverfahren. Diese Nickelschicht enthält optional einen Anteil eines Dotiermaterials z.B. 10% Phosphor. Die Nickelschicht wird dann lokal in den Gräben stark erwärmt, beispielsweise durch Einsatz eines weiteren Laser, um eine Diffusion des Dotiermaterials bzw. Phosphors in das Silizium zu erreichen.

Optional kann eine Kantenisolation an den Seitenwänden der Gräben erfolgen.

### Variante 2:

Es wird ein Wafer ohne metallisierte Rückseite verwendet. In die Anti-Reflex-Schicht werden mittels Laser mehrere Gräben geschnitten. Dies erfolgt wie bei Variante 1. Ebenso kann ein entsprechendes Reinigen erfolgen genauso wie das Einbringen des Kontakt- und Dotiermaterials.

Das Substrat wird durch einen weiteren Hochtemperaturofen gefahren (900-1100C°) zur lokal Erwärmung in den Gräben, um eine Diffusion des Phosphors in die aktive Schicht zu erreichen. Die Vorderseite kann durch einen photogalvanischen Prozess verstärkt werden. Die Rückseite kann anschließend mit Aluminium oder Silber bedruckt werden.

## Patentansprüche

1. Verfahren zur Bearbeitung von Solarzellen (11), die auf einer Oberseite (14) eine aktive Schicht (13) mit einer Anti-Reflex-Schicht (15) darüber aufweisen, mit den Schritten:
- Erzeugen von mehreren Gräben (22) in der Anti-Reflex-Schicht (15) mittels Laser (20a), die bis auf die aktive Schicht (13) darunter reichen,
- Einbringen von Kontaktmaterial (30) nur in den Graben (22) bzw. auf den Grabenboden (23),
- Erwärmen (20b) bzw. Erhitzen des Kontaktmaterials (30) in den Gräben (22) zur Verbindung mit dem Material (25) der angrenzenden aktiven Schicht (13),
wobei das Erwärmen bzw. Erhitzen des Kontaktmaterials (30) lokal nur in dem Kontaktmaterial (30) in den Gräben durch Bestrahlung nur des Kontaktmaterials mit einem Laser (20b) stattfindet.

2. Verfahren nach Anspruch 1, **dadurch gekennzeichnet, dass** nach dem Erzeugen der Gräben (22) in der Anti-Reflex-Schicht (13) eine Reinigung (27) der Solarzellen (11) bzw. ihrer Oberseite (14) an der Anti-Reflex-Schicht (13) vorgenommen wird, vorzugsweise zur Beseitigung von Verunreinigungen oder Abscheidungen in den gebildeten Gräben (22) bzw. auf dem Grabenboden (23).

3. Verfahren nach Anspruch 2, **dadurch gekennzeichnet, dass** die Reinigung eine Spülung ist, vorzugsweise eine alkalische Spülung bzw. eine HF-Spülung.

4. Verfahren nach einem der vorhergehenden Ansprüche, **dadurch gekennzeichnet, dass** das Kontaktmaterial galvanisch eingebracht wird, vorzugsweise verstärkt durch ein Photogalvanikvertahren.

5. Verfahren nach einem der Ansprüche 1 bis 3, **dadurch gekennzeichnet, dass** das Kontaktmaterial chemisch eingebracht wird.

6. Verfahren nach einem der Ansprüche 1 bis 3, **dadurch gekennzeichnet, dass** das Kontaktmaterial in flüssiger oder pastöser Form durch einen Druckvorgang eingebracht wird, vorzugsweise durch ein Tintenstrahl-Druckverfahren.

7. Verfahren nach einem der vorhergehenden Ansprüche, **dadurch gekennzeichnet, dass** das eingebrachte Kontaktmaterial (30) Nickel aufweist.

8. Verfahren nach einem der vorhergehenden Ansprüche, **dadurch gekennzeichnet, dass** eine Dotierung der aktiven Schicht im Bereich des Grabens (22) durch Dotiermaterial erfolgt, wobei vorzugsweise das Dotiermaterial dem Kontaktmaterial beigemischt ist als Kontakt- und Dotiermaterial (30).

9. Verfahren nach Anspruch 8, **dadurch gekennzeichnet, dass** das Dotiermaterial Phosphor aufweist, vorzugsweise Phosphor ist, wobei insbesondere das Kontakt- und Dotiermaterial (30) NiP ist.

10. Verfahren nach einem der vorhergehenden Ansprüche, **dadurch gekennzeichnet, dass** das aufgebrachte Kontakt- und Dotiermaterial (30) Kontakte (30) bzw. Kontaktbahnen bildet, vorzugsweise die vorderen Kontakte einer Solarzelle (11) bildet, insbesondere nach dem erneuten Erwärmen des Materials (30).

11. Verfahren nach einem der vorhergehenden Ansprüche, **dadurch gekennzeichnet, dass** die seitlichen Kanten der Gräben (22) isoliert werden, vorzugsweise durch ein Aufbringen einer lsolierschicht.

## Claims

1. Method for processing solar cells (11) comprising on a top side (14) an active layer (13) with an antireflection layer (15) thereabove, comprising the following steps:
- producing a plurality of trenches (22) in the antireflection layer (15) by means of a laser (20a), said trenches reaching as far as the active layer (13) thereunder,
- introducing contact material (30) only into the trench (22) or onto the trench bottom (23),
- warming (20b) or heating the contact material (30) in the trenches (22) for connection to the material (25) of the adjoining active layer (13),
wherein warming or heating the contact material (30) takes place locally only in the contact material (30) in the trenches by the irradiation of only the contact material by means of a laser (20b).

2. Method according to Claim 1, **characterized in that**, after producing the trenches (22) in the antireflection layer (13), cleaning (27) of the solar cells (11) or of their top side (14) at the antireflection layer (13) is performed, preferably in order to eliminate contaminants or depositions in the trenches (22) formed or on the trench bottom (23).

3. Method according to Claim 2, **characterized in that** the cleaning is a purging, preferably an alkaline purging or an HF purging.

4. Method according to any of the preceding claims, **characterized in that** the contact material is introduced by plating, preferably in a manner reinforced by a photoplating method.

5. Method according to any of Claims 1 to 3, **characterized in that** the contact material is introduced chemically.

6. Method according to any of Claims 1 to 3, **characterized in that** the contact material is introduced in liquid or pasty form by a printing process, preferably by an inkjet printing method.

7. Method according to any of the preceding claims, **characterized in that** the contact material (30) introduced comprises nickel.

8. Method according to any of the preceding claims, **characterized in that** the active layer is doped in the region of the trench (22) by doping material, wherein the doping material is preferably admixed with the contact material as contact and doping material (30).

9. Method according to Claim 8, **characterized in that** the doping material comprises phosphorus, preferably is phosphorus, wherein, in particular, the contact and doping material (30) is NiP.

10. Method according to any of the preceding claims, **characterized in that** the contact and doping material (30) applied forms contacts (30') or contact tracks preferably forms the front contacts of a solar cell (11), in particular after renewed warming of the material (30).

11. Method according to any of the preceding claims, **characterized in that** the lateral edges of the trenches (22) are insulated, preferably by an insulating layer being applied.

## Revendications

1. Procédé de traitement de cellules solaires (11) qui présentent sur une face supérieure (14) une couche active (13) recouverte par une couche anti-réfléchissante (15), le procédé comportant les étapes qui consistent à :
- former plusieurs sillons (22) dans la couche anti-réfléchissante (15) au moyen d'un laser (20a), ces sillons s'étendant jusqu'à la couche active (13) en dessous,
- amener un matériau de contact (30) uniquement dans les sillons (22) ou sur le fond (23) des sillons,
- chauffer (20b) le matériau de contact (30) placé dans les sillons (22) pour le relier au matériau (25) de la couche active (13) adjacente,
le chauffage du matériau de contact (30) n'ayant lieu que localement, uniquement dans le matériau de contact (30) présent dans les sillons, en irradiant uniquement le matériau de contact à l'aide d'un laser (20b).

2. Procédé selon la revendication 1, **caractérisé en ce qu'**après la formation des sillons (22) dans la couche anti-réfléchissante (13), un nettoyage (27) de la couche anti-réfléchissante (13) des cellules solaires (11) ou de leur face supérieure (14) est réalisé, de préférence pour éliminer les impuretés ou les dépôts présents dans les sillons (22) qui ont été formés ou sur le fond (23) des sillons.

3. Procédé selon la revendication 2, **caractérisé en ce que** le nettoyage est un lavage, de préférence un lavage alcalin ou un lavage au HF.

4. Procédé selon l'une des revendications précédentes, **caractérisé en ce que** le matériau de contact est apporté par voie galvanique, de préférence avec renforcement par un procédé photogalvanique.

5. Procédé selon l'une des revendications 1 à 3, **caractérisé en ce que** le matériau de contact est apporté chimiquement.

6. Procédé selon l'une des revendications 1 à 3, **caractérisé en ce que** le matériau de contact est appliqué sous forme liquide ou pâteuse par une opération d'impression, de préférence par une opération d'impression à jet d'encre.

7. Procédé selon l'une des revendications précédentes, **caractérisé en ce que** le matériau de contact (30) apporté présente du nickel.

8. Procédé selon l'une des revendications précédentes, **caractérisé en ce que** la couche active est dopée par un matériau de dopage au niveau de la rainure (22), le matériau de dopage étant de préférence mélangé au matériau de contact en tant que matériau de contact et de dopage (30).

9. Procédé selon la revendication 8, **caractérisé en ce que** le matériau de dopage présente du phosphore et est de préférence constitué de phosphore, le matériau de contact et de dopage (30) étant en particulier le NiP.

10. Procédé selon l'une des revendications précédentes, **caractérisé en ce que** le matériau de contact et de dopage (30) apporté forme des contacts (30') ou des pistes de contact, de préférence les contacts avant d'une cellule solaire (11), en particulier après un nouveau chauffage du matériau (30).

11. Procédé selon l'une des revendications précédentes, **caractérisé en ce que** les chants latéraux des sillons (22) sont isolés, de préférence en y appliquant une couche isolante.
